# EUROPEAN PATENT SPECIFICATION

(11) **EP 4 531 093 B1**
(45) Date of publication and mention of the grant of the patent: **02.09.2026**
(21) Application number: 24202581.5
(22) Date of filing: 25.09.2024
(51) Int. Cl.: H10W 70/40, H10W 70/68, H10W 70/692, H10W 70/05, H10W 70/60, H10W 90/00, H10W 99/00, H10P 90/00, H10W 70/685

(54) **PACKAGING SUBSTRATE AND MANUFACTURING METHOD OF THE SAME**
VERPACKUNGSSUBSTRAT UND HERSTELLUNGSVERFAHREN DAFÜR
SUBSTRAT D'EMBALLAGE ET SON PROCÉDÉ DE FABRICATION

(30) Priority: 27.09.2023 US 202363540930 P
(43) Date of publication of application: 02.04.2025
(73) Proprietor: Absolics Inc., Covington, GA 30014 (US)
(72) Inventor: KIM, Tae Kyoung, 30014 Covington, Georgia (KR); LEE, Chun Jae, 18469 Hwaseong-si, Gyeonggi-do (KR); KIM, Sungjin, 30014 Covington, Georgia (KR)
(74) Representative: BCKIP Part mbB

(56) References cited:
- JP-A- 2017 073 424
- JP-A- 2017 118 053
- US-A1- 2013 005 222
- US-A1- 2015 334 823
- US-A1- 2021 351 094
- US-A1- 2023 215 772

## Description

This application claims the priority of U.S. Provisional Patent Application No. 63/540,930, filed September 27, 2023.

### BACKGROUND

### 1. Field

The embodiments relate to a semiconductor packaging substrate and a manufacturing method of the semiconductor packaging substrate, and a packaging substrate comprising a glass core and a manufacturing method thereof.

### 2. Description of Related Art

In manufacturing electronic components, implementing a circuit on a semiconductor wafer is called the front-end process (FE), and assembling the wafer into a state that can be used in an actual product is called the back-end process (BE: Back-End). The packaging process is included in the latter process. Examplified by JP 2017 118053 A.

The four core technologies of the semiconductor industry that have recently enabled the rapid development of electronic products include semiconductor technology, semiconductor packaging technology, manufacturing process technology, and software technology. Semiconductor technology is developing in various forms, such as line widths of micro or nanoscale, more than 10 million cells, high-speed operation, and high heat dissipation, but the technology to package it perfectly is relatively unsupported. Accordingly, the electrical performance of a semiconductor is determined by packaging technology and the resulting electrical connection rather than the performance of the semiconductor technology itself.

Ceramics or resins are used as materials for packaging substrates, but recent research is in progress on applying silicon or glass as high-end packaging substrates. In particular, packaging substrates with a cavity structure have been developed by applying glass substrates.

Meanwhile, during the packaging process, Re-Distribution Layer (RDL) uses wafer level package (WLP) process technology to change the position of already formed electrical terminals (ex: Al Pad) to a random position. It refers to a general term for technology. These RDLs are used to overcome design limitations in semiconductor manufacturing plants through packaging, that is, they are used to stack semiconductor chips.

Related prior art includes Korean Patent Registration No. 10-1458663 and Korean Patent Publication No. 10-2012-0096003.

### SUMMARY

The purpose of the embodiment is to provide a packaging substrate on which a plurality of devices is mounted on the glass core and a manufacturing method of the same. The packaging substrate can protect the glass core or the packaging substrate from external impact and can minimize damage and breakage of the glass core in a glass core.

In addition, the purpose of the embodiment is to provide a packaging substrate that can protect corners or edge portions of the glass core or packaging substrate and minimize defects, and a manufacturing method for the same.

Additionally, the purpose of the embodiment is to alleviate external shock when seating or moving the glass core or packaging substrate on a tray.

In order to achieve the above object, a packaging substrate according to one embodiment includes a glass core including a first surface and a second surface facing each other; and an upper layer stacked on the first surface or a lower layer laminated on the second surface.

The edges of the packaging substrate is entirely curved.

The edges of the glass core is entirely curved
The glass core may have a square shape, and one or more vertices of the glass core may be rounded.

The upper layer and/or the lower layer may each have a tapered shape that becomes thinner in the direction of a cut surface of the glass core.

The edge of the package substrate where the corner portion is rounded has a substrate curvature radius

The substrate curvature radius of the glass core or the package substrate may be 0.5 mm or more and 8 mm or less.

The curvature radius of corner of the packaging substrate is referred to as the side curvature radius.

The side curvature radius of the package substrate may be 0.05 mm or more.

In order to achieve the above object, a manufacturing method of a packaging substrate according to one embodiment includes a forming operation of an upper layer on the first side or a lower layer on the second side of a glass core including a first side and a second side facing each other; a forming operation of a cut portion on the first or second side along a predetermined cutting line; a cutting operation of the glass core along the cut portion to expose the cut surface; and a grinding operation of the cut surface.

The upper layer includes an insulating layer, and in the forming operation of the cut portion, the insulating layer on the cut line may be removed.

The cutting operation of the glass core may be performed by dicing sawing or laser cutting.

Alternatively, according to another example, the grinding operation of the cut surface includes a process of entirely curving the cut surface.

The cut glass core may have a square shape.

During the grinding operation of the cutting surface, one or more vertices of the glass core may be entirely curved.

The grinding operation of the cut surface may include a roughing process (first process) of the cut surface with a wheel having a first mesh at a first speed or higher; and a finishing machining process (second process) of the cut surface at a speed lower than the first speed using a wheel having a second mesh larger than the first mesh.

### BRIEF DESCRIPTION OF THE DRAWINGS

FIG. 1 is a conceptual diagram explaining a cross-sectional structure of a packaging substrate according to an embodiment.
FIG. 2 is a conceptual diagram explaining a cross-sectional structure of a packaging substrate according to another embodiment.
(a) and (b) of FIG. 3 are conceptual diagrams illustrating a portion of a packaging substrate according to an embodiment in cross section, respectively.
FIG. 4 is a flowchart illustrating in cross section the operations for preparing a core distribution layer in the manufacturing method of a packaging substrate according to an embodiment.
FIG. 5 is a flowchart illustrating in cross section the operations for preparing an insulating layer in the manufacturing method of a packaging substrate according to an embodiment.
(a) to (c) of FIG. 6 are views for explaining a cross section of a glass core according to an embodiment.
FIG. 7 is a diagram illustrating movement of a packaging substrate according to an embodiment; (a) is a conventional example of being seated on a tray (an example of cracks or chipping occurring in the glass core), and (b) is an example of an embodiment (an example of being seated while sliding along the curved surface of the substrate).
FIG. 8 is a flowchart illustrating the manufacturing method of a packaging substrate according to an embodiment in cross-section; (a)is a diagram illustrating laser ablation (V-Grooving), (b) is snapping, and (c) is a diagram illustrating grinding.
FIG. 9A is a diagram explaining a grinder according to an embodiment; S represents a spindle, W represents a wheel, and T represents the height of the wheel's machining portion, which is more than the thickness of the substrate.
FIG. 9B is a diagram illustrating grinding of a packaging substrate according to an embodiment and the arrow indicates the direction of progress.
FIG. 10A to FIG. 10C are photographs taken in the manufacturing method of a glass core according to an embodiment; Fig. 10A is a cross-section after V-grooving, where H means a hackle, V means V-groove, Fig. 10b is a cross-section after snapping, and Fig. 10c is a cross-section (b) of a corner of a packaging substrate curved.
FIG. 11 is a photograph of a glass substrate viewed from above and a portion thereof according to another embodiment.

### DETAILED DESCRIPTION

Hereinafter, one or more embodiments will be described in detail by referring to the accompanying drawings so that the skilled person in the technical field to which the invention belongs may easily implement it. However, the embodiments may be implemented in several different forms and are not limited to the embodiments described herein. The same reference numerals are attached to similar parts throughout the specification.

Through the present specification, the term "combination thereof" included in the expression of the Markush form means one or more mixtures or combinations selected from the group consisting of the components described in the Markush type expression, and it comprises one or more selected from the group consisting of the above components.

In the present specification, terms such as "first", "second", or "A", "B" are used to distinguish the same terms from each other unless otherwise specified. Additionally, a singular expression is interpreted as meaning including a singular or plural interpreted in the context unless otherwise described.

In this specification, the "~" system may mean that the compound includes a compound corresponding to "~" or a derivative of "~".

In this specification, the meaning that B is located on A means that B is located directly on A or B is located on A while another layer is located in between and is not interpreted as being limited to B being located on A's surface.

In this specification, being connected to B on A means that A and B are directly connected or connected through other components between A and B. Unless otherwise specified, A and B are not construed as being directly connected.

In the present specification, singular expressions are interpreted as meaning including singular or plural interpreted in context unless otherwise specified.

In the process of developing semiconductor devices that can perform more integrated and thinner, the inventors recognized that not only the device itself but also the packaging was an important factor in performance improvement and continued their research. While studying this, the inventors confirmed that the packaging substrate can be made thinner and more helpful in improving the electrical properties of the semiconductor element by applying a single layer of glass core and a cavity structure, unlike the application of two or more cores on the motherboard such as existing interposer and organic substrate.

On the other hand, there is a possibility that the glass substrate may crack or chipping split into pieces due to internal stress and/or external impact during the process. In particular, when the packaging substrate is placed in a tool such as a tray or boat for post-processing, the substrate is highly likely to be damaged, so the need to improve damage and damage for the substrate's movement and post-processing was recognized.

Accordingly, if the cut surface of the packaging substrate is treated with a curved edge or curved vertex area rather than a straight cross section or a chamfer is formed, damage to the substrate can be minimized, and the invention was completed.

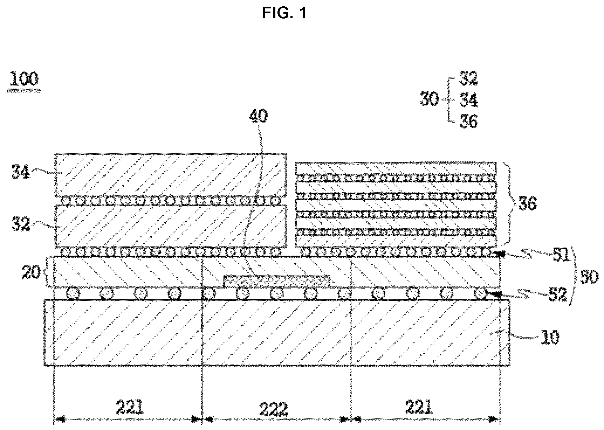

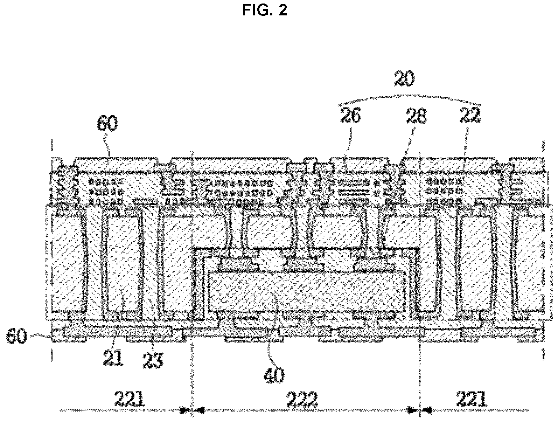

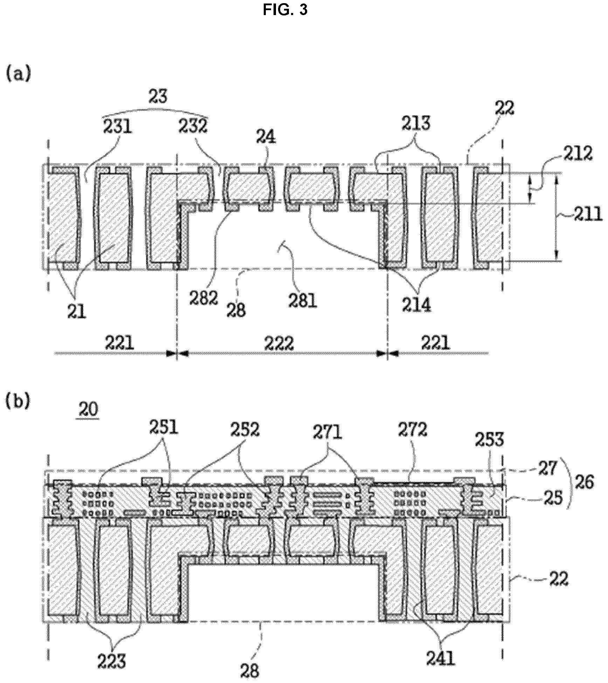

FIG. 1 is a conceptual diagram explaining a cross-sectional structure of a packaging substrate according to an embodiment. FIG. 2 is a conceptual diagram explaining a cross-sectional structure of a packaging substrate according to another embodiment. (a) and (b) of FIG. 3 are conceptual diagrams illustrating a portion of a packaging substrate according to an embodiment in cross section, respectively.

In order to achieve the above object, a semiconductor device 100 according to the embodiment comprises a semiconductor element portion 30 in which one or more semiconductor elements 32, 34, and 36 are located, a packaging substrate 20 electrically connected to the semiconductor elements; and a motherboard 10 that is electrically connected to the packaging substrate 20 and transmits an external electrical signal to the semiconductor elements 32, 34, and 36.

The packaging substrate 20 according to an embodiment comprises a core layer 22, an upper layer 26 located on one surface of the core layer 22, and a cavity portion 28 in which a cavity element 40 may be located.

The semiconductor element portion 30 refers to elements mounted in the semiconductor device, and is mounted on the packaging substrate 20 by a connection electrode or the like. Specifically, as the semiconductor element portion 30, for example, arithmetic elements (a first element 32 and a second element 34) such as a central processing unit (CPU), a graphics processing unit (GPU), and the like, a storage element (a third element 36) such as a memory chip, and the like may be applied, but any semiconductor element mounted on a semiconductor device may be applied without limitation.

A motherboard such as a printed circuit board, a printed wiring board, or the like may be applied as the motherboard 10.

The packaging substrate 20 may selectively further comprise a lower layer (not shown) located under the core layer.

The core layer 22 may comprise a glass substrate 21 comprising a first region 221 having a first thickness 211 and a second region 222 adjacent to the first region 221 and having a second thickness 212 thinner than the first thickness; a plurality of core vias 23 passing through the glass substrate 21 in a thickness direction, and a core distribution layer 24 that is located on a surface of the glass substrate 21 or the core via 23 and electrically connects a first surface 213 of the glass substrate 21 and a second surface 214 facing the first surface 213 through the core vias 23. That is, the core layer 22 may refer to a glass structure, which is the glass substrate 21 comprising the first surface 213 and the second surface 214 facing each other, the core vias 23, and the cavity portion 28, or all of these.

The second region 222 of the core layer 22 may serve as a cavity structure.

In the same region, the glass substrate 21 has the first surface 213 and the second surface 214 facing each other, and these two surfaces are generally parallel to each other and have uniform thicknesses throughout the glass substrate 21.

An inner space 281 formed by a thickness difference between the first region 221 and the second region 222 serves to accommodate parts or all of the cavity element 40.

The glass substrate 21 may comprise the core vias 23 passing through the first surfaces 213 and the second surfaces 214. The core vias 23 may be formed in both the first region 221 and the second region 222, and may be formed with an intended pitch and pattern.

Conventionally, a form in which a silicon substrate and an organic substrate are stacked was applied as a packaging substrate for a semiconductor device. In the case of silicon substrates, there is a concern that parasitic elements might be occurred when applied to a high-speed circuit due to its nature of semiconductor, and a disadvantage in that power loss is relatively large. Further, in the case of organic substrates, a large area is required to form a more complicated distribution pattern, but this does not conform to the trend of manufacturing miniaturized electronic devices. In order to form a complicated distribution pattern within a predetermined size, pattern miniaturization is substantially required, but there is a practical limit to pattern miniaturization due to the nature of materials such as polymers and the like applied to organic substrates.

In the embodiment, as a method of solving such problems, the glass substrate 21 is applied as a support of the core layer 22. Further, a packaging substrate 20 having a relatively shortened electrical flow, a relatively compact size, a faster response, and less loss characteristics is provided by applying the core vias 23 formed to pass through the glass substrates 21 along with the glass substrate 21.

As the glass substrate 21, a glass substrate applied to a semiconductor may be applied, and for example, a borosilicate glass substrate, an alkali-free glass substrate, or the like may be applied, but the present disclosure is not limited thereto.

The core vias 23 passes through the glass substrate 21. The core vias 23 may be formed by a method of removing predetermined regions of the glass substrate 21, and may be formed by physically and/or chemically etching plate-shaped glass.

Specifically, the formation of the core vias 23 may be performed by chemically etching or laser etching, or the like after forming defects (flaws) on the surface of the glass substrate using a method such as a laser, but the present disclosure is not limited thereto.

The number of core vias 23 located in the glass substrate 21 based on a unit area (1 cm x 1 cm) may be 100 to 3,000, 100 to 2,500, or 225 to 1,024. When this pitch condition is satisfied, the formation of an electrically conductive layer and the like and a performance of a packaging substrate may be improved.

The core distribution layer 24 comprises a core distribution pattern 241 which is an electrically conductive layer electrically connecting the first surface and the second surface of the glass substrate through through-vias, and a core insulating layer 223 surrounding the core distribution pattern 241. The core layer 22 may be formed with the electrically conductive layer therein through the core vias to serve as an electrical path crossing the glass substrate 21, and may connect upper and lower portions of the glass substrate with a relatively short distance to have characteristics of faster electrical signal transmission and low loss. For example, a copper-plated layer may be applied as the electrically conductive layer, but the present disclosure is not limited thereto.

The shape of the cavity portion 28 is substantially not limited to a shape such as a circular shape, a triangular shape, a quadrangular shape, a hexagonal shape, an octagonal shape, a cross shape, and the like.

The shape of the cavity element 40 may generally be a cylindrical shape, rectangular parallelepiped shape, or a polygonal pillar shape.

The cavity portion 28 may comprise a cavity distribution pattern, which is an electrically conductive layer electrically connecting the cavity element 40 and the core distribution layer 24, and an insulating layer which surrounds the cavity distribution pattern.

Meanwhile, a cavity portion according to another embodiment may be implemented in the form of passing through the first surface 213 and the second surface 214 of the glass substrate 21. In this case, the cavity portion may be formed according to the same process as a process of forming the core via 23, and the area and shape passing through the glass substrate 21 may be different from those of the core via 23.

In this embodiment, after the cavity element 40 is arranged in the cavity portion, an insulating layer may be formed. That is, the insulating layer may also be generated in the cavity portion through a process of generating the above-described core insulating layer 223.

The core distribution pattern 241 may be formed to be electrically connected to the cavity element 40.

The cavity element 40 may comprise an active element such as a transistor or a power transmission element such as a multilayer ceramic capacitor (MLCC), that is, a passive element.

When an element such as a transistor serving to convert an electrical signal between a motherboard and a semiconductor element portion to an appropriate level is applied as the cavity element 40, since a transistor or the like is applied to the path of the packaging substrate 20, a more efficient and faster semiconductor device 100 may be provided.

Further, a power transmission element such as a multilayer ceramic capacitor (MLCC) plays an important role in the performance of a semiconductor element. Generally, at least 200 or more power transmission elements, which are passive elements, are applied to a semiconductor element, and performance thereof is also affected by the characteristics of an electrically conductive layer around the element in power transmission. In one embodiment, a core via having a non-circular shape rather than a circular shape may be applied to a place where a low-resistance electrically conductive layer is required, such as a power transmission element.

Meanwhile, a passive element such as a capacitor or the like may be individually inserted into and applied to the cavity element 40, and an element group comprising a plurality of passive elements in the form of being embedded between insulator layers (cavity element insulating layers) may be formed such that electrodes are exposed, and then inserted into the cavity element. In the latter case, the workability of manufacturing the packaging substrate may become smoother, and there is a relative advantage in that the insulating layer is sufficiently and reliably located in a space between complicated elements.

The glass substrate 21 serves as an intermediate and intermediary, which connect the semiconductor element portion 30 and the motherboard 10 at an upper portion and a lower portion, respectively, and the core vias 23 serve as paths through which the electrical signals thereof are transmitted, and thus smoothly transmit the signals. In order to distinguish it from the core via of the second region 222, which will be described later, the core via disposed in the first region 221 is called the first region core via 231.

The upper layer 26 is located on the first surface 213.

The upper layer 26 comprises an upper distribution layer 25 and an upper surface connection layer 27 located on the upper distribution layer 25, and the uppermost surface of the upper layer 26 may be protected by a cover layer 60 formed with an opening that may come into direct contact with the connection electrode of the semiconductor element portion.

The upper distribution layer 25 comprises an upper insulating layer 253 located on the first surface, and an upper distribution pattern 251 embedded in the upper insulating layer 253 as an electrically conductive layer having a predetermined pattern and to which the core distribution layer 24 is at least partially connected. The upper distribution layers 25 arranged above and below each other may be connected to each other through blind vias 252.

Any one which is applied as an insulator layer in a semiconductor element or a packaging substrate may be applied as the upper insulating layer 253, for example, an epoxy-based resin or the like comprising a filler may be applied, but the present disclosure is not limited thereto.

The insulator layer may be formed by a method of forming and curing a coating layer, and may also be formed by a method of laminating an insulator film formed to be a film in an uncured or semi-cured state on the core layer 22 and curing the insulator film. In this case, when a pressure sensitive lamination method or the like is applied, since the insulator is incorporated into a space in the core via 23, an efficient process may be performed.

According to one embodiment, even when multi-layer insulator layers are stacked and applied, it may become difficult to substantially distinguish the insulator layers, and a plurality of insulator layers are collectively called an upper insulation layer. Further, the same insulating material may be applied to the core insulating layer 223 and the upper insulating layer 253, and in this case, a boundary therebetween may not be substantially distinguished. Alternatively, according to another embodiment, the boundary of the insulator layers may be generated by setting the pressure and temperature for curing the multi-layer insulator layers differently.

The upper distribution pattern 251 refers to an electrically conductive layer located in the upper insulating layer 253 in a preset form, and may be formed, for example, using a buildup layer method. Specifically, the upper distribution pattern 251 formed with an electrically conductive layer in a vertical direction or horizontal direction in an intended pattern may be formed by repeating a method of forming an insulator layer, removing unnecessary portions of the insulator layer, forming an electrically conductive layer by a method of copper plating or the like, selectively removing unnecessary portions of the electrically conductive layer, forming another insulator layer on the electrically conductive layer, removing the unnecessary portions again, and then forming an electrically conductive layer by a plating method or the like.

The upper distribution pattern 251 is located between the core layer 22 and the semiconductor element portion 30, and thus is formed to comprise a micro pattern in at least a portion thereof so that transmission of the electrical signals with the semiconductor element portion 30 may be smoothly performed and an intended complicated pattern may be sufficiently accommodated. In this case, each of a width and an interval of the micro pattern may be smaller than 4 µm, 3.5 µm or less, 3 µm or less, or 2.5 µm or less, or may be 1 to 2.3 µm (hereinafter, descriptions for the micro pattern are the same).

At least a portion of the upper surface connection layer 27 is electrically connected to the upper distribution pattern 251, and the upper surface connection layer 27 comprises an upper surface connection pattern 272 located on the upper insulating layer 253 and an upper surface connection electrode 271, which electrically connects the semiconductor element portion 30 and the upper surface connection pattern 272.

The upper surface connection pattern 272 may be located on one surface of the upper insulating layer 253, and may be embedded in the upper insulating layer while at least a portion of the upper surface connection pattern 272 may be exposed on the upper insulating layer. For example, when the upper surface connection pattern is located on one surface of the upper insulating layer, the upper insulating layer may be formed by a plating method or the like, and a case in which the upper surface connection pattern is embedded in the upper insulating layer while the portion of the upper surface connection pattern is exposed on the upper insulating layer may be a case in which a portion of the insulating layer or electrically conductive layer is removed by a method such as surface polishing, surface etching, or the like after a copper-plated layer or the like is formed.

At least a portion of the upper surface connection pattern 272 may comprise a micro pattern like the above-described upper distribution pattern 251. The upper surface connection pattern 272 comprising the micro pattern allows a relatively larger number of elements to be connected even in a small area to make an electrical signal connection between the elements or with the outside smooth, and more integrated packaging is possible.

The upper surface connection electrode 271 may be directly connected to the semiconductor element portion 30 through a terminal or the like, and may also be connected to the semiconductor element portion 30 through an element connection portion 51 such as a solder ball.

The cavity portion 28 is located on and/or under the second region 222 and comprises a cavity distribution layer 282 electrically connected to the core distribution pattern 241 and the inner space 281 in which the cavity element 40 is located. The cavity distribution layer 282 may be formed through the second resin core via 232.

Specifically, the thickness of the glass substrate 21 in the second region 222 is thinner than the thickness of the glass substrate 21 in the first region 221, and the cavity element 40 may be located at the inner space 281 formed due to the thickness difference. Further, the core vias 23 and the core distribution layer 24 formed in the glass substrate 21 serve as an electrical connection structure connecting the cavity element 40 and external elements.

Further, as described above, in the second region 222 other than the first region 221, that is, a cavity portion in the form of passing through the first surface 213 and the second surface 214 of the glass substrate 21 may be prepared, and the cavity element 40 may be arranged in the cavity portion.

The packaging substrate 20 is also connected to the motherboard 10. A terminal of the motherboard 10 may be directly connected to the core distribution pattern 241 located on at least a portion of the second surface 214 of the core layer 22, and the motherboard 10 may be electrically connected to the core distribution pattern 241 through a board connection portion 52 such as a solder ball. Further, the core distribution pattern 241, which encounters the motherboard 10, may be connected to the motherboard 10 through a lower layer (not shown) located under the core layer 22. An element connection part 51 and a board connection part 52 are collectively referred to as a connection part 50.

According to an example, other additional substrates other than the glass substrate 21 may not be substantially applied to the packaging substrate 20 located between the semiconductor element portion 30 and the motherboard 10.

Conventionally, an interposer and an organic substrate were stacked together and applied between an element and a motherboard while connecting an element and the motherboard because a multi-stage form is applied for at least two reasons. One is that there is a scale problem in directly bonding a micro pattern of the element to the motherboard; and the other is that a problem of wiring damage due to a difference in thermal expansion coefficient may occur during a bonding process or a process of driving the semiconductor device. In the embodiment, this problem was solved by applying a glass substrate having a thermal expansion coefficient similar to that of a semiconductor element, and forming a micro pattern having a sufficiently fine scale for mounting the element on the first surface and an upper layer of the glass substrate.

Hereinafter, a manufacturing method of a packaging substrate according to the embodiment of the present disclosure will be described.

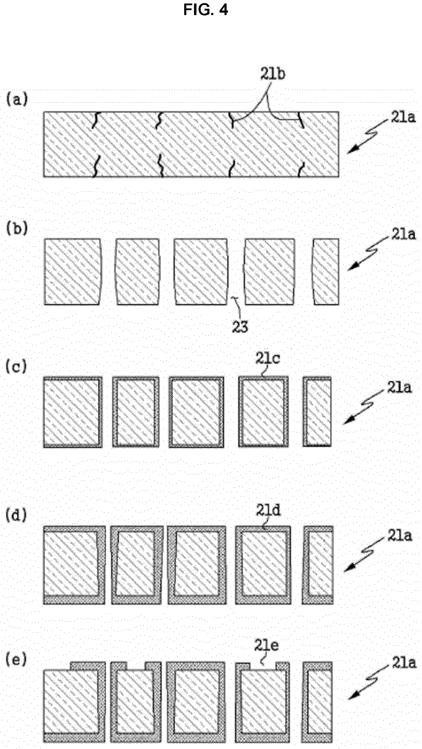

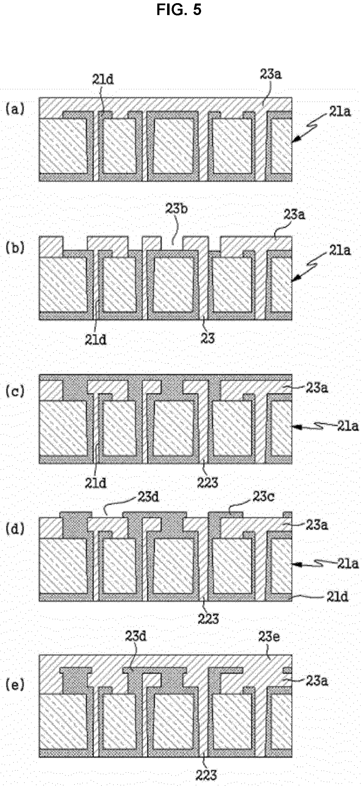

FIGS. 4 and 5 are flowcharts for describing the packaging substrate manufacturing process according to the embodiment in cross-sections.

First, as shown in (a) of FIG. 4, a glass substrate 21a having flat first and second surfaces is prepared, and defects (flaws) 21b are formed at predetermined positions in a glass surface to form core vias. A glass applied to a substrate of an electronic device or the like may be applied as the glass substrate, for example, an alkali-free glass substrate may be applied as the glass substrate, but the present disclosure is not limited thereto. As commercially available products, products manufactured by manufacturers such as Corning, Schott, AGC, and the like may be applied. A method such as mechanical etching, laser irradiation, or the like may be applied to the formation of the defects (flaws).

As shown in (b) of FIG. 4, in the glass substrate 21a having the defects (flaws) 21b, an etching operation of forming the core vias 23 through a physical or chemical etching process is performed. During the etching process, the vias are formed in defective portions of the glass substrate, and the surface of the glass substrate 21a may also be etched. In order to prevent etching of the glass surface, a masking film or the like may be applied, but considering the inconvenience of applying and removing the masking film, the defective glass substrate itself may be etched, and in this case, a thickness of the glass substrate having the core vias may be somewhat thinner than the initial thickness of the glass substrate.

Thereafter, as shown in (c) and (d) of FIG. 4, a core layer manufacturing operation may be performed by forming an electrically conductive layer 21d on the glass substrate. A metal layer comprising copper metal may be representatively applied as the electrically conductive layer, but the present disclosure is not limited thereto.

Since the surface of the glass (comprising the surface of the glass substrate and a surface of the core via) and the surface of the copper metal have different properties, adhesion is low. In the embodiment, the adhesion between the glass surface and the metal may be improved by two methods such as a dry method and a wet method.

The dry method is a method of applying sputtering, that is, a method of forming a seed layer 21c on the glass surface and an inner diameter of the core via through metal sputtering. Dissimilar metals such as titanium, chromium, and nickel may be sputtered together with copper to form the seed layer, and in this case, a glass-metal adhesion may be improved by an anchor effect, in which metal particles interact with the surface morphology of the glass, or the like.

The wet method is a method of performing primer treatment, and is a method of forming a primer layer 21c by performing pre-treatment with a compound having a functional group such as an amine. The primer treatment may be performed with a compound or particles having an amine functional group after performing pre-treatment with a silane coupling agent according to the degree of intended adhesion. As mentioned above, a support substrate of the embodiment needs to have to have high enough performance to form a micro pattern, and this should be maintained even after primer treatment. Accordingly, when such a primer comprises nanoparticles, nanoparticles having an average diameter of 150 nm or less may be applied, for example, nanoparticles having an amine group may be applied. The primer layer may be, for example, formed by applying a bonding strength improving agent, e.g., the CZ series manufactured by MEC or the like.

In the seed layer/primer layer 21c, the electrically conductive layer may selectively form the metal layer in a state in which unnecessary portions for the formation of the electrically conductive layer are removed or not removed. Further, in the seed layer/primer layer 21c, portions required or not required for the formation of the electrically conductive layer in an activated or deactivated state may be treated selectively with metal plating to perform subsequent processes. For example, light irradiation treatment such as a laser of a certain wavelength or the like, chemical treatment, or the like may be applied to the activation or deactivation treatment. A copper plating method or the like applied to semiconductor element manufacturing may be applied to the formation of the metal layer, but the present disclosure is not limited thereto.

As shown in (e) of FIG. 4, a portion of the core distribution layer may be removed when unnecessary, and after a portion of the seed layer is removed or deactivated, metal plating may be performed to form an electrically conductive layer in a predetermined pattern, and then form an etching layer 21e of the core distribution layer.

FIG. 5 describes a manufacturing operation of forming an insulating layer and an upper distribution pattern according to one embodiment.

As shown in (a) of FIG. 5, the core via may go through an insulating layer forming operation of filling an empty space with an insulating layer after forming the core distribution layer which is the electrically conductive layer. In this case, an insulating layer manufactured in the form of a film may be applied as the insulating layer to be applied, and for example, a pressure sensitive lamination method of the insulating layer in the form of a film, or the like may be applied. When the pressure sensitive lamination is performed like in this way, the insulating layer is sufficiently incorporated into the empty space in the core via to form a core insulating layer in which a void is not formed.

(b) to (e) of FIG. 5 describe a forming operation of an upper layer.

The forming operation of an upper layer is an operation of forming an upper distribution layer comprising an upper insulating layer and an upper distribution pattern on the core layer. The upper insulating layer may be formed by a method of coating a resin composition forming an insulating layer 23a or laminating insulating films, and for convenience, the method of laminating the insulating films is better. The laminating of the insulating films may be performed by a process of laminating and curing the insulating films, and in this case, when the pressure sensitive lamination method is applied, an insulating resin may be sufficiently incorporated even into a layer in which the electrically conductive layer is not formed in the core via or the like. An upper insulating layer which comes into direct contact with at least a portion of the glass substrate, and thus has sufficient adhesion is applied as the upper insulating layer. Specifically, the glass substrate and the upper insulating layer may have characteristics in which adhesion test values according to ASTM D3359 satisfy 4B or more.

The upper distribution pattern may be formed by repeating the process of forming an insulating layer 23a, and forming an electrically conductive layer 23c in a predetermined pattern and etching unnecessary portions to form an etching layer 23d of the electrically conductive layer, and electrically conductive layers formed adjacent to each other with the insulating layer therebetween may be formed by a method of performing a plating process after forming a blind via 23b in the insulating layer. A dry etching method such as laser etching, plasma etching, or the like, a wet etching method using a masking layer and an etchant, or the like may be applied to the formation of the blind via.

Hereinafter, although not shown in the drawings, an upper surface connection layer and a cover layer may be formed.

The upper surface connection pattern and the upper surface connection electrode may also be formed in a process similar to forming the upper distribution layer. Specifically, the upper surface connection pattern and the upper surface connection electrode may be formed by a method of forming an etching layer of the insulating layer on an insulating layer 23e, forming an electrically conductive layer thereon, and then forming an etching layer of the electrically conductive layer, or the like, but a method of selectively forming only the electrically conductive layer without applying an etching method may also be applied. The cover layer may be formed so that an opening (not shown) may be formed at a position corresponding to the upper surface connection electrode and thus the upper surface connection electrode is exposed, and the cover layer may be directly connected to an element connection portion, a terminal of an element, or the like.

When the upper layer is formed, a forming operation of the lower layer may be performed by forming a lower connection layer and the cover layer. A lower distribution layer and/or the lower connection layer, and selectively, the cover layer (not shown) may be formed in a manner similar to the above-described operation of forming the upper surface connection layer and cover layer.

According to an embodiment, one or more semiconductor elements may be mounted on the packaging substrate 20. Before or after mounting, the large-area substrate may be cut into a packaging substrate 20 of a predetermined unit, that is, a unit. That is, the packaging substrate or glass substrate (core substrate or core layer) may have a pattern of a predetermined size and may be cut in a state in which individual semiconductor chips or chip units. Such cutting, separation, and division processes of the substrate may be referred to as dicing or singulation.

In the present specification, dicing or singulation means dividing a packaging substrate comprising a glass substrate as a core layer into several units. In addition, a substrate on which a glass substrate is used as a core layer may be referred to as a core substrate, a glass substrate, a packaging substrate, etc.

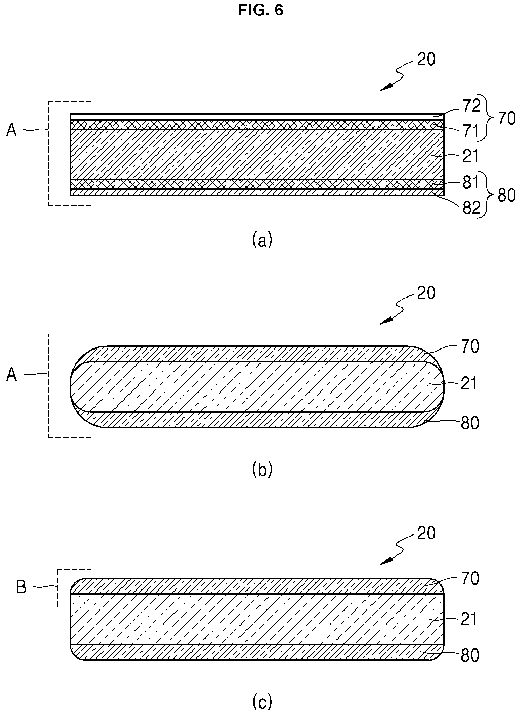

(a) to (c) of FIG. 6 are views for explaining a cross section of a packaging substrate according to an embodiment.

As described with reference to FIGS. 1 to 5, a core via and a cavity portion may be formed on the glass substrate 21, a core distribution layer and a cover layer may be formed on the upper layer, and the lower layer may also have a multilayer structure comprising an insulating layer and a metal distribution pattern. In the following drawings, for convenience of explanation, the packaging substrate 20 comprising the glass substrate 21, the upper layer 70 formed on the first surface of the glass substrate 21, and the lower layer 80 formed on the second surface will be briefly described, and detailed descriptions of the remaining detailed configurations will be omitted.

According to an embodiment illustrated in FIG. 6, an upper layer 70 is disposed on a first surface of a glass substrate 21. Selectively, a lower layer 80 may be disposed on a second surface of the glass substrate 21.

The upper layer 70 may comprise an upper distribution layer 71 having a multilayer stacked structure comprising an upper metal pattern (upper distribution pattern) and an upper insulating layer, and a first cover layer 72 formed on the upper distribution layer 71 to protect the substrate. The lower layer 80 may also comprise a lower distribution layer 81 formed in a multilayer structure comprising a lower metal pattern (lower distribution pattern) and a lower insulating layer, and a second cover layer 82 formed on the lower distribution layer 81 to protect the substrate. The specific arrangement of the upper distribution pattern and the upper insulating layer in the upper distribution layer is omitted from the expression of the drawing. And arrangement of the lower distribution pattern and the lower insulating layer in the lower distribution layer is omitted from the drawing.

The first cover layer 72 and the second cover layer 82 may be implemented as a solder resist for protecting the surface circuit from external environment. Alternatively, according to an embodiment, the first cover layer 72 and the second cover layer 82 may be implemented as a polyimide film (PI) which is a heat-resistant insulating film having high thermal stability and high mechanical strength.

A core via, a cavity portion, and/or a metal pattern layer and the like are formed on the glass substrate 21, and the packaging substrate may be cut into a specific unit. The cut packaging substrate 20 may have a cross section as shown in (a) of FIG. 6. The packaging substrate may be cut according to a predetermined cutting line, and a metal pattern layer may not be prepared in a portion of the upper layer 70 and/or lower layer 80 corresponding to the cutting line. That is, a portion of the upper layer 70 and/or lower layer 80 that is cut may comprise only an insulating layer and/or a protective layer.

As shown, the cut surface A of the cut area (dotted line portion) of the packaging substrate 20 is generally perpendicular to the first or second surface, and the corners may have a sharp straight line.

In a structure such as (a) of FIG. 6, there is a high possibility of damage due to external impact at the edge area of the cut surface A during movement and post-processing of the packaging substrate 20. Damage to the packaging substrate or glass core, even if there is some damage to the corners, affects multiple other packaging substrates or glass cores arranged in the chamber. In addition, due to the nature of the packaging substrate manufacturing process, which is usually carried out in a reduced pressure clean room with automated equipment, such damage causes unintentional particle defects, so cleaning of the process space must be performed, which leads to a decrease in yield. Therefore, in order to reduce the possibility of such damage, a packaging substrate as shown in (b) or (c) of FIG. 6 is proposed according to an embodiment of the present invention.

As shown in (b) of FIG. 6, the cut surface A of the packaging substrate 20 is entirely curved or, as shown in (c) of FIG. 6, the edge area B may be chamfered. That is, the cut surface of the packaging substrate 20 is entirely curved, or the edges may be chamfered to form an obtuse angle rather than a right angle.

The cut surface or corner area of the packaging substrate 20 has the shape shown in (b) of FIG. 6 through a grinding process after cutting. In other words, the glass core 21, upper layer 70, and lower layer 80 in the packaging substrate 20 may be ground to have a tapered shape that becomes thinner in the direction of the cutting surface.

When forming an entirely curved cut surface, the upper layer 70 and/or lower layer 80 of the glass core 21 is ground that is, entirely curved, like the glass core 21. Alternatively, according to another embodiment, only the upper layer 70 or the lower layer 80 of the packaging substrate 20 may be ground without grinding the glass core 21.

Alternatively, depending on the embodiment, the packaging substrate 20 may have the upper layer 70 formed only on the first side of the glass core 21, and the lower layer 80 may not be formed on the second side. In this case, during edge processing as shown in (c) of FIG. 6, the upper layer 70 and the second surface of the glass core 21 may be ground.

Additionally, depending on the embodiment, the glass core 21 and the packaging substrate 20 may have a square shape, and when grinding the edge area of the cut surface, the vertex area may be rounded. The curvature of the ground vertex can be derived to an appropriate value by being set based on the diameter that has the smallest deviation from the predetermined target value.

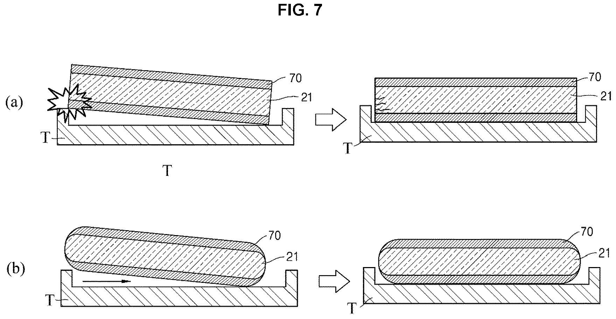

FIG. 7 is a diagram illustrating movement of a packaging substrate according to an embodiment.

(a) of FIG. 7 illustrates a case in which a conventional packaging substrate, that is, a core substrate having a glass structure, is placed on a tray, and (b) of FIG. 7 illustrates a case in which a core substrate is placed on a tray T according to an embodiment of the present disclosure.

As illustrated, if the cut surface of the packaging substrate has a straight cross-section rather than a curve, that is, if the edge portion formed by the upper and lower surfaces of the packaging substrate with the cut surface is not round but sharp, the glass core is more prone to impact and crack or chipping may occur in the glass core. In other words, when an existing packaging substrate is incorrectly seated on a tray or boat, the possibility of damage to the glass core increases due to the angular edge shape.

On the other hand, if the cut surface is rounded or chamfered according to the embodiment, it may slide along the curved surface of the substrate and be seated on the tray or boat when the packaging substrate is seated on the tray or boat. Accordingly, the impact between the tray and the packaging substrate may be alleviated, and the possibility of occurrence of defects due to damage or the like may be reduced.

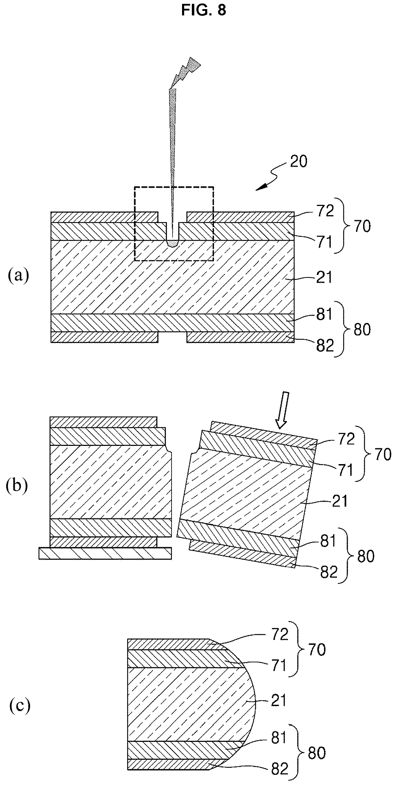

FIG. 8 is a flowchart illustrating a manufacturing method of a packaging substrate according to an embodiment in cross section.

As shown in (a) of FIG. 8, an upper layer 70 is formed on the first surface of the glass core 21, and a lower layer 80 is formed on the second surface. According to another embodiment, only the upper layer 70 may be formed on the first surface of the glass core 21, and the lower layer may not be formed on the lower surface. A semiconductor element may be mounted on the upper layer 70 (not shown).

First, as shown in (a) of FIG. 8, a V-Grooving may be formed in the glass core 21 while removing the upper layer 70 by a predetermined width along a predetermined cut line using a laser or the like (Laser Ablation, V-Grooving). The V-groove serves as a cutting part in which the cutting line is displayed on the upper layer or the lower layer, and the cutting line may be displayed by removing a part of the first surface or the second surface of the glass core together with the removal of the upper layer or the lower layer.

Specifically, the stacked upper layer 70, specifically the insulating layer such as ABF, is removed along a cutting line such as Dicing Street using a green laser or an ultraviolet laser, and a V-Grooving may be formed in the glass core 21.

The depth of the V-groove may be formed to a depth of about 1% to 25% of the thickness of the glass core 21. The depth of the V-groove may be 1% or more, 3% or more, 5% or more, or 10% or more of the thickness of the glass core 21. Furthermore, the depth of the V-groove may be 25% or less, 20% or less, or 15% or less of the thickness of the glass core 21. The laser output intensity and the number of processing times may be optimized according to the thickness of the upper layer 70 and the glass core 21, and the depth of the V- groove may be adjusted correspondingly.

As shown in (a) of FIG. 8, a removing operation of the upper layer 70 and an operation of generating defects in the glass core 21 may be simultaneously performed in a single operation. In addition, according to another embodiment, the removing operation of the upper layer 70 by varying the intensity and type of the laser and the operation of generating defects in the glass core 21 may be separately performed.

After the upper layer 70 is removed, the upper layer 70 may have a tapered shape that becomes thinner along the cut surface of the glass core 21.

Then, as shown in (b) of FIG. 8, the packaging substrate 20 may be cut and separated along a cut portion such as a V-groove (Snapping). In this case, the packaging substrate 20 may be separated into a predetermined product unit based on a physical force such as tension or rotational force.

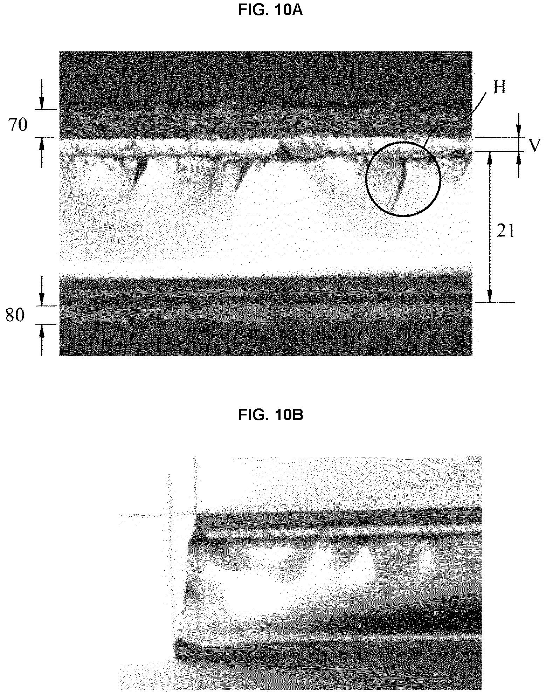

After the packaging substrate 20 is separated in this way, there may be V-groove marks by lasers and hacks such as bird feather shapes (see FIG. 10A). A Slant Cut may occur in which the glass core 21 is cut into an inclined shape without being broken vertically (see FIG. 10B). That is, when the glass core 21 is cut using external torque or the like, it may be in an incomplete form in appearance.

According to another embodiment, the glass core 21 may be separated using a laser or a dicing saw.

When the packaging substrate 20 is separated based on various methods, a cut surface can be ground to have a curved surface, as shown in (c) of Fig. 8.

An operation of grinding the cut surface may comprise an operation of forming a chamfer at a corner of the cut surface. According to another embodiment, the operation of grinding the cut surface may comprise an operation of curved treating the cut surface by applying a grinding device.

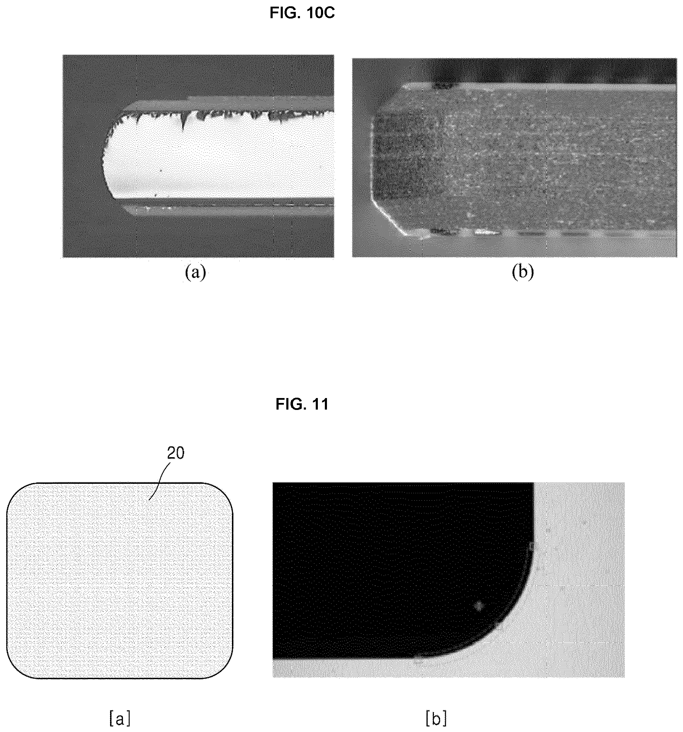

There is an uneven right-angle deviation in the cut surface of the cut and unprocessed glass core, and there is a risk of additional damage such as cracks or chipping in the cut corner. A glass core having an entirely curved edge is provided through grinding (see FIG. 10C). This can significantly reduce the risk of further damage. In addition, external shocks can be properly dispersed even when transporting trays for the movement or additional process of glass cores or packaging substrates, and defects due to cracks or chipping can be minimized.

In another embodiment, the packaging substrate 20 having a cut surface may be rounded so that the corner portion has a curved surface when viewed from above (see FIG. 11). The rectangular packaging substrate has four corners when viewed from above, and each corner is processed to have a predetermined curvature to remove an angled part. This radius of curvature is called a substrate curvature radius. The substrate curvature radius may be 0.5 mm or more, 1 mm or more, 1.2 mm or more, or 1.5 mm or more. The substrate curvature radius may be 8 mm or less, 7 mm or less, 6 mm or less, or 5 mm or less. In this case, the occurrence of corner cracks, etc. can be minimized and at the same time, the area where the electrically conductive layers of the upper and/or lower layers are disposed can be stably secured.

In another embodiment, the packaging substrate 20 having a cut surface may be ground on a side surface corresponding to the thickness when viewed from the side (or cross-section). For example, the shape of the ground side is a shape in which the edge where the side and top of the packaging substrate meet is chamfered (Flat Edge), and the side connecting the top and bottom is rounded and ground so that the central part of the side protrudes (Pencil Edge) and the like.

The side (edge) of the packaging substrate 20 may be straight immediately after the cut surface is formed, or a portion of the glass may be broken, and may be manufactured into a shape having a constant radius of curvature by grinding it. At this time, the radius of curvature is called a side curvature radius.

The side curvature radius of the packaging substrate 20 is greater than or equal to 0.05 mm, 0.1 mm or more, 0.15 mm or more, or 0.2 mm or more. The side curvature radius may be 2.0 mm or less, 1.8 mm or less, 1.6 mm or less, 1.2 mm or less, 1 mm or less, 0.8 mm or less, or 0.6 mm or less. In this case, workability can be improved by minimizing the occurrence of breakage of the packaging substrate or glass substrate during manufacturing and transportation.

For example, when grinding is performed by setting the design angle of the blade to 90°±1° and the cutting amount to 0.08 to 0.14 mm, a packaging substrate with an edge curvature radius of 0.241 mm can be manufactured.

Additionally, as an example, when grinding is performed by setting the design angle of the blade to 120°±1° and the cutting amount to 0.05 to 0.12 mm, a packaging substrate with an edge curvature radius of 0.522 mm can be manufactured.

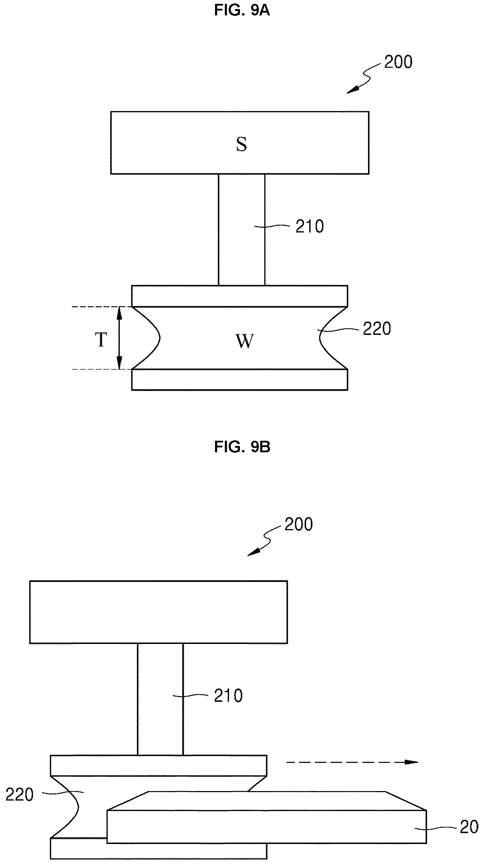

FIG. 9A is a view illustrating a grinder according to an embodiment, and FIG. 9B is a view illustrating grinding of a packaging substrate according to an embodiment.

As illustrated, a grinder 200 may comprise a wheel (WHELL) 220 that grinds the packaging substrate, a shaft (SPINDLE) 210 for rotating the wheel 210, and a driving unit of a wheel 210 that is not illustrated.

The wheel 210, which is a processing part for processing the packaging substrate, has a shape processed by the curvature of the final packaging substrate so that the corners of the packaging substrate may be curved. That is, the cross-section of the wheel 210 has a round shape corresponding to the curvature of the packaging substrate to be processed, and the height of the wheel 210 in contact with the cutting surface of the packaging substrate is preferably greater than or equal to the substrate thickness.

Depending on the embodiment, the virtual curved surface in contact with the cutting surface of the wheel 210 may have a diameter of 5 mm to 20 mm. The diameter may be 5 mm or more, 8 mm or more, or 10 mm or more. The diameter may be 20 mm or less, 18 mm or less, or 15 mm or less.

The roughness of the wheel 210 may be expressed as a mesh.

According to embodiments, a cutting surface roughness of the wheel 210 may be about 600 mesh to 1400 mesh. The cutting surface roughness may be 600 mesh or more, 700 mesh or more, 800 mesh or more, or 900 mesh or more. The cutting surface roughness may be 1,400 mesh or less, 1,300 mesh or less, 1,200 mesh or less, or 1,100 mesh or less.

As shown in FIG. 9B, after positioning a packaging substrate (unit size or quarter panel size) to be processed on the wheel 210 of the grinder 200, the edge of the packaging substrate 20 may be ground while moving the grinder 200 according to a predetermined direction of progress.

According to an example, a wet grinding method in which cutting water or cutting oil is sprayed onto the wheel 210 and proceeds may be applied.

The grinding speed may be 10 mm/min to 500 mm/min.

The cutting surface of the packaging substrate 20 may be grounded (removed) by 50 µm to 300 µm. The cutting surface may be grounded (removed) by 100 µm to 200 µm.

Depending on the embodiment, a grinding process comprises a roughing procedure of the cut surface of the packaging substrate 20 at a first speed or higher with a wheel having a first mesh and a grinding procedure of the cut surface at a first speed or lower with a wheel having a second mesh larger than the first mesh.

According to one example, the roughness of the wheel may each have a mesh value in the above-mentioned range. Additionally, the difference between the first mesh and the second mesh may be 400 mesh or more, 450 mesh or more, or 500 mesh or more.

As the mesh value increases, the roughness of the wheel 210 becomes weaker. The packaging substrate 20 may be initially roughed using a wheel having strong roughness and then finished processed using a wheel having a larger mesh, softer roughness than the mesh applied during roughing.

During rough machining, the moving speed of the wheel 210 may be a predetermined speed, for example, 200 mm/sec to 400 mm/sec. The speed may be 200 mm/sec or more, 220 mm/sec or more, 240 mm/sec or more, 260 mm/sec or more, or 280 mm/sec or more. The speed may be 400 mm/sec or less, 380 mm/sec or less, 360 mm/sec or less, or 340 mm/sec or less. A finishing machining can proceed at a speed lower than that of roughing machining.

According to another embodiment, a grinding process may be performed once, or may be processed three or more times. Alternatively, the number of processing times may be set differently depending on the part of the packaging substrate.

FIGS. 10A to 10C are photographs taken in the manufacturing process of a packaging substrate according to an embodiment.

FIG. 10A is a photograph of a cross-sectional view of a packaging substrate on which V-grooving was formed according to the process in (a) of FIG. 8. For observation purposes, a cut surface was formed on the packaging substrate sample and observed. As shown in FIG. 10A, an upper layer with ABF and SR is formed on the first surface, which is the upper surface of the glass core, and a lower layer with ABF and SR is formed on the second surface, which is the lower surface.

When a laser is irradiated on the upper layer of a packaging substrate with this structure, a V-shaped groove, that is, a cut part (defect) is generated, and a hackle H resembling a bird's feather can be observed in the glass core along with the V groove.

FIG. 10B is a photograph taken of a cross-section of a packaging substrate separated according to the cutting process (snapping) of (b) of Figure 8. According to an embodiment, when the packaging substrate is separated using a force applied to a defect rather than cutting by a laser or dicing, the cut surface is inclined without being broken vertically, but may be biased to one side and separated into a diagonal shape. In addition, the cut surface of the packaging substrate may have an uneven appearance surface, and cracks or pieces of damage may occur on the cut surface.

FIG. 10C is a photograph of a cross section of a packaging substrate after a grinding process as shown in (c) of FIG. 8.

As shown in the left picture ofFIG. 10C, the packaging substrate may be rounded. As shown in the right picture oFIG. 10C, chamfering may be formed at corners. Through this grinding, various incomplete defects occurring in the cut surface may be removed.

The packaging substrate may have corners removed by polishing in a range of approximately 10 µm to 400 µm, or for example, 50 µm to 300 µm. After grinding, the packaging substrate has a tapered shape thinning in the direction of the cut surface.

As shown in the right picture oFIG. 10C, the edge of the packaging substrate can be deformed into a C-shape or R-shape chamfer through grinding.

Meanwhile, according to an embodiment, the vertex of the rectangular packaging substrate may also be curved through grinding. When the vertex portion is ground, the risk of damage or breakage may be reduced when moving the packaging substrate or transporting it to a tray or the like. The curvature of the ground vertex portion may be derived as an appropriate value by setting a diameter in which the deviation from the predetermined target value occurs smallest.

The embodiments described above may minimize defects such as cracks and chipping occurring at edges or corners of the substrate when the packaging substrate is placed on a tool such as a tray or boat for post-processing after the semiconductor chip is mounted. Through this, durability and reliability of the packaging substrate can be secured by protecting the packaging substrate from external impact.

The packaging substrate and manufacturing method thereof of the embodiment can protect the glass core or packaging substrate from external impact and minimize a damage and a breakage of the glass core or packaging substrate.

Additionally, the embodiment provides a packaging substrate that can protect corners or edges of the glass core or packaging substrate and minimize defects, and a manufacturing method therefor.

Additionally, the embodiment can alleviate external shock when seating or moving the glass core or packaging substrate on a tray.

## Claims

1. A packaging substrate (20), comprising
a glass core (21) comprising a first surface and a second surface facing each other; and
an upper layer (70) stacked on the first surface, and a lower layer (80) stacked on the second surface,
wherein the upper layer (70) comprises an upper distribution layer (71) having a multilayer stacked structure comprising an upper metal pattern, an upper insulating layer, and a first cover layer (72) formed on the upper distribution layer (71) configured to protect the packaging substrate (20),
wherein a corner of the packaging substrate (20) is entirely curved in a thickness direction, and the corner of the packaging substrate (20) forms a continuous curved surface extending from the side surface of the glass core (21) to the first cover layer (72).

2. The packaging substrate (20) of Claim 1,
wherein the glass core (21) has a square shape, and
vertices of the glass core (21) are entirely curved.

3. The packaging substrate of Claim 1 or Claim 2,
wherein the upper layer (70) or the lower layer (80) has a tapered shape thinning in the direction of a cut surface (A) of the glass core (21).

4. The packaging substrate (20) of Claim 2,
wherein the corner of the package substrate (20) is entirely curved and has a substrate curvature radius, and the substrate curvature radius is 0.5 mm or more and 8 mm or less.

5. The packaging substrate (20) of any one from Claim 1 to Claim 4,
wherein a curvature radius of the corner of the packaging substrate (20) is a side curvature radius, and
the side curvature radius of the packaging substrate (20) is 0.05 mm or more.

6. A manufacturing method of the packaging substrate (20) according to Claim 1, comprising
a forming operation of the upper layer (70) on the first surface and the lower layer (80) on the second surface, wherein the first surface and the second surface is comprised in the glass core (21) and facing each other;
a forming operation of a cut portion on any one from the group of the upper layer (70), the first surface, the lower layer (80), the second surface and a combination thereof along a predetermined cutting line;
a cutting operation of the glass core (21) along the cut portion to expose a cut surface (A); and
a grinding operation of the cut surface (A),
wherein the grinding operation is performed by a grinder (200) comprising a wheel (220) that grinds the packaging substrate (20), a shaft (210) for rotating wheel (220), and a driving unit,
wherein the cross-section of the wheel (220) has a round shape corresponding to the curvature of the packaging substrate to be processed, and a height (T) of the wheel (220) in contact with the cutting surface of the packaging substrate (20) is greater than or equal to the packaging substrate (20), and
wherein the grinding operation comprises simultaneously grinding the cut surface (A) of the glass core (21) and the first cover layer (72) using the wheel (220) to form the continuous curved corner, a step of positioning the packaging substrate (20) to be processed on the wheel (220) of the grinder (200) and a step of grinding while moving the grinder (200) according to a predetermined direction of progress.

7. The manufacturing method of Claim 6,
wherein the upper layer (70) or the lower layer (80) comprises an insulating layer, and
the insulating layer on the cut line is removed in the forming operation of a cut portion.

8. The manufacturing method of Claim 6 or Claim 7,wherein the cutting operation is performed by dicing sawing or laser cutting.

9. The manufacturing method of any one from Claim 6 to Claim 8,
wherein the grinding operation of the cut surface (A) comprises curving treatment procedure of the cut surface (A).

10. The manufacturing method of any one from Claim 6 to Claim 9,
wherein the cut glass core (21) has a square shape, and vertices of the glass core (21) are entirely curved during the grinding operation of the cut surface (A).

11. The manufacturing method of any one from Claim 6 to Claim 10,
wherein the grinding operation of the cut surface (A) comprises:
a rough machining procedure of the cut surface (A) at a first speed or higher with a wheel having a first mesh;
a finishing procedure of the cut surface (A) at a speed lower than the first speed with a wheel having a second mesh, and
wherein the second mesh is larger than the first mesh.

## Patentansprüche

1. Verpackungssubstrat (20), umfassend:
einen Glaskern (21), der eine erste Oberfläche und eine zweite Oberfläche, die einander zugewandt sind, umfasst; und
eine auf der ersten Oberfläche gestapelte obere Schicht (70) und eine auf der zweiten Oberfläche gestapelte untere Schicht (80),
wobei die obere Schicht (70) eine obere Verteilungsschicht (71) mit einer mehrschichtigen Stapelstruktur umfasst, die ein oberes Metallmuster, eine obere Isolierschicht und eine erste Deckschicht (72), die auf der oberen Verteilungsschicht (71) ausgebildet ist und so konfiguriert ist, dass sie das Verpackungssubstrat (20) schützt, umfasst,
wobei eine Ecke des Verpackungssubstrats (20) in einer Dickenrichtung vollständig verrundet ist und die Ecke des Verpackungssubstrats (20) eine kontinuierlich verrundete Oberfläche bildet, die sich von der Seitenfläche des Glaskerns (21) zu der ersten Deckschicht (72) erstreckt.

2. Verpackungssubstrat (20) nach Anspruch 1,
wobei der Glaskern (21) eine quadratische Form aufweist, und Eckpunkte des Glaskerns (21) vollständig verrundet sind.

3. Verpackungssubstrat (20) nach Anspruch 1 oder Anspruch 2,
wobei die obere Schicht (70) oder die untere Schicht (80) eine sich in Richtung der Schnittfläche (A) des Glaskerns (21) verjüngende Keilform aufweist.

4. Verpackungssubstrat (20) nach Anspruch 2,
wobei die Ecke des Verpackungssubstrats (20) vollständig verrundet ist und einen Substratverrundungsradius aufweist, und der Substratverrundungsradius 0,5 mm oder mehr und 8 mm oder weniger beträgt.

5. Verpackungssubstrat (20) nach einem der Ansprüche 1 bis 4,
wobei ein Verrundungsradius der Ecke des Verpackungssubstrats (20) ein Seitenverrundungsradius ist, und
der Seitenverrundungsradius des Verpackungssubstrats (20) 0,05 mm oder mehr beträgt.

6. Herstellungsverfahren für das Verpackungssubstrat (20) nach Anspruch 1, umfassend:
einen Vorgang des Ausbildens der oberen Schicht (70) auf der ersten Oberfläche und der unteren Schicht (80) auf der zweiten Oberfläche, wobei die erste Oberfläche und die zweite Oberfläche in dem Glaskern (21) enthalten sind und einander zugewandt sind;
einen Vorgang des Ausbildens eines Schnittabschnitts an einer beliebigen aus der Gruppe bestehend aus der oberen Schicht (70), der ersten Oberfläche, der unteren Schicht (80), der zweiten Oberfläche und einer Kombination davon entlang einer vorbestimmten Schnittlinie;
einen Vorgang des Schneidens des Glaskerns (21) entlang des Schnittabschnitts, um eine Schnittfläche (A) freizulegen; und
einen Vorgang des Schleifens der Schnittfläche (A),
wobei der Vorgang des Schleifens durch eine Schleifmaschine (200) durchgeführt wird, die ein Schleifrad (220), das das Verpackungssubstrat (20) schleift, eine Welle (210) zum Drehen des Schleifrads (220) und eine Antriebseinheit umfasst,
wobei der Querschnitt des Schleifrads (220) eine runde Form aufweist, die der Verrundung des zu bearbeiteten Verpackungssubstrats entspricht, und eine Höhe (T) des Schleifrads (220), das in Kontakt mit der Schnittfläche des Verpackungssubstrats (20) steht, größer oder gleich dem Verpackungssubstrat (20) ist, und
wobei der Vorgang des Schleifens das gleichzeitige Schleifen der Schnittfläche (A) des Glaskerns (21) und der ersten Deckschicht (72) unter Verwendung des Schleifrads (220) umfasst, um die kontinuierlich verrundete Ecke auszubilden, einen Schritt des Positionierens des zu bearbeitenden Verpackungssubstrats (20) auf dem Schleifrad (220) der Schleifmaschine (200) und einen Schritt des Schleifens, während die Schleifmaschine (200) entsprechend einer vorbestimmten Vorschubrichtung bewegt wird.

7. Herstellungsverfahren nach Anspruch 6,
wobei die obere Schicht (70) oder die untere Schicht (80) eine Isolierschicht umfasst, und
die Isolierschicht an der Schnittlinie bei dem Vorgang des Ausbildens eines Schnittabschnitts entfernt wird.

8. Herstellungsverfahren nach Anspruch 6 oder 7, wobei der Vorgang des Schneidens durch Dicing-Sägen oder Laserschneiden durchgeführt wird.

9. Herstellungsverfahren nach einem der Ansprüche 6 bis 8,
wobei der Vorgang des Schleifens der Schnittfläche (A) einen Vorgang des Verrundungsbearbeitens der Schnittfläche (A) umfasst.

10. Herstellungsverfahren nach einem der Ansprüche 6 bis 9,
wobei der geschnittene Glaskern (21) eine quadratische Form aufweist und die Eckpunkte des Glaskerns (21) während des Vorgangs des Schleifens der Schnittfläche (A) vollständig verrundet werden.

11. Herstellungsverfahren nach einem der Ansprüche 6 bis 10,
wobei der Vorgang des Schleifens der Schnittfläche (A) umfasst:
einen Vorgang des Grobbearbeitens der Schnittfläche (A) bei einer ersten Geschwindigkeit oder höher mit einem Schleifrad mit einer ersten Körnung; einen Vorgang des Endbearbeitens der Schnittfläche (A) bei einer Geschwindigkeit, die niedriger als die erste Geschwindigkeit ist, mit einem Schleifrad mit einer zweiten Körnung, und
wobei die zweite Körnung feiner als die erste Körnung ist.

## Revendications

1. Substrat d'encapsulation (20), comprenant
un noyau en verre (21) comprenant une première surface et une deuxième surface se faisant face ; et
une couche supérieure (70) superposée à la première surface, et une couche inférieure (80) superposée à la deuxième surface,
où la couche supérieure (70) comprend une couche de distribution supérieure (71) ayant une structure à plusieurs couches empilées comprenant un motif métallique supérieur, une couche isolante supérieure et une première couche de revêtement (72) formée sur la couche de distribution supérieure (71) prévue pour protéger le substrat d'encapsulation (20),
où un coin du substrat d'encapsulation (20) est arrondi en continu dans le sens de l'épaisseur, et le coin du substrat d'encapsulation (20) forme une surface courbe continue s'étendant de la surface latérale du noyau en verre (21) à la première couche de revêtement (72).

2. Substrat d'encapsulation (20) selon la revendication 1,
où le noyau en verre (21) a une forme carrée, et
les sommets du noyau en verre (21) sont arrondis en continu.

3. Substrat d'encapsulation selon la revendication 1 ou la revendication 2,
où la couche supérieure (70) ou la couche inférieure (80) ont une forme effilée s'amincissant dans la direction d'une surface de découpe (A) du noyau en verre (21).

4. Substrat d'encapsulation (20) selon la revendication 2,
où le coin dudit substrat d'encapsulation (20) est arrondi en continu et présente un rayon de courbure de substrat, et où ledit rayon de courbure de substrat est compris entre 0,5 mm et 8 mm.

5. Substrat d'encapsulation (20) selon l'une des revendications 1 à 4, où un rayon de courbure du coin du substrat d'encapsulation (20) est un rayon de courbure latérale, et
où le rayon de courbure latérale du substrat d'encapsulation (20) est égal ou supérieur à 0,05 mm.

6. Procédé de fabrication du substrat d'encapsulation (20) selon la revendication 1, comprenant
un processus de formation de la couche supérieure (70) sur la première surface et de la couche inférieure (80) sur la deuxième surface, la première surface et la deuxième surface étant incluses dans le noyau en verre (21) et se faisant face ;
un processus de formation d'une partie de découpe sur un élément quelconque du groupe comprenant la couche supérieure (70), la première surface, la couche inférieure (80), la deuxième surface et une combinaison de celles-ci le long d'une ligne de découpe prédéterminée ;
un processus de découpe du noyau en verre (21) le long de la partie de découpe pour exposer une surface de découpe (A) ; et
un processus de rectification de la surface de découpe (A),
où le processus de rectification est exécuté par une meule (200) comprenant une roue (220) rectifiant le substrat d'encapsulation (20), un arbre (210) pour entraîner la roue (220) en rotation, et une unité d'entraînement,
où la section transversale de la roue (220) présente une forme ronde correspondant à la courbure du substrat d'encapsulation à usiner, et une hauteur (T) de la roue (220) en contact avec la surface de découpe du substrat d'encapsulation (20) est supérieure ou égale au substrat d'encapsulation (20), et
où le processus de rectification comprend la rectification simultanée de la surface de découpe (A) du noyau en verre (21) et de la première couche de revêtement (72) au moyen de la roue (220) de manière à former le coin arrondi en continu, une étape de positionnement du substrat d'encapsulation (20) à usiner sur la roue (220) de la meule (200), et une étape de rectification en déplaçant la meule (200) dans une direction d'avance prédéterminée.

7. Procédé de fabrication selon la revendication 6,
où la couche supérieure (70) ou la couche inférieure (80) comprennent une couche isolante, et où la couche isolante sur la ligne de découpe est retirée lors du processus de formation d'une partie de découpe.

8. Procédé de fabrication selon la revendication 6 ou la revendication 7, où le processus de découpe est réalisé par découpe en dés ou découpe au laser.

9. Procédé de fabrication selon l'une des revendications 6 à 8,
où le processus de rectification de la surface de découpe (A) comprend une procédure de traitement de courbure de la surface de découpe (A).

10. Procédé de fabrication selon l'une des revendications 6 à 9,
où le noyau en verre découpé (21) a une forme carrée, et les sommets du noyau en verre (21) sont arrondis en continu pendant le processus de rectification de la surface de découpe (A).

11. Procédé de fabrication selon l'une des revendications 6 à 10, où le processus de rectification de la surface de découpe (A) comprend :
une procédure d'usinage grossier de la surface de découpe (A) à une première vitesse ou à une vitesse supérieure avec une roue présentant un premier maillage ;
une procédure de finition de la surface de découpe (A) à une vitesse inférieure à la première vitesse avec une roue présentant un deuxième maillage, et
où le deuxième maillage est plus large que le premier maillage.
